# EUROPEAN PATENT APPLICATION

(11) **EP 2 560 010 A1**
(43) Date of publication of application: **20.02.2013**
(21) Application number: 11756259.5
(22) Date of filing: 14.03.2011
(51) Int. Cl.: G01R 1/067, G01R 1/073, G01R 31/26

(54) **CONTACT PROBE AND PROBE UNIT**

(30) Priority: 15.03.2010 JP 2010057703
(71) Applicant: NHK Spring Co., Ltd., Kanagawa 236-0004 (JP)
(72) Inventor: MOTEGI, Takahiro, Kanagawa 236-0004 (JP); MATSUI, Akihiro, Kanagawa 236-0004 (JP); ISHIKAWA, Koji, Kanagawa 236-0004 (JP)
(74) Representative: HOFFMANN EITLE
(86) International application number: PCT/JP2011/055969
(87) International publication number: WO 2011/115074

(57) **Abstract**

A contact probe (20) having a substantially flat plate shape, used to connect different substrates and having a uniform plate thickness includes: a first contact portion (21) which has a side surface curved in an arc shape and which makes contact with one substrate at the side surface thereof; a second contact portion (22) which has a side surface curved in an arc shape and which makes contact with the other substrate at the side surface thereof; a connection portion (23) which connects the first contact portion (21) and the second contact portion (22); and an elastic portion (24) which extends from the second contact portion (22), has a portion curved in an arc shape, and is elastically deformed by a load applied to the first contact portion (21) and the second contact portion (22).

## Description

### Field

The present invention relates to a contact probe and a probe unit used for connection between electric circuit boards, and the like.

### Background

When a continuity state test or an operating characteristic test is conducted on a test object such as a semiconductor integrated circuit and a liquid crystal panel, a probe unit that accommodates a plurality of conductive contact probes has been used to attempt an electric connection between the test object and a signal processor that outputs a signal for testing. In probe units, the progress in recent years in high integration and miniaturization of a semiconductor integrated circuit and a liquid crystal panel entails advancement in technology that is applicable to a highly integrated and miniaturized test object by narrowing a pitch between contact probes.

A technology related to a contact probe in a shape of an elastic wire that can be bent in correspond to a load applied from an outside of the contact probe is known as a technology for narrowing a pitch between contact probes, for example. A contact probe in a shape of a wire is easy to be thin when compared to a contact probe in a shape of a pin using a spring. However, in a case where bending directions fail to be uniform when a load is applied, there is a concern that neighboring contact probes come into contact with each other, or a variation occurs in a contact with a contact object. Thus, with regard to the contact probe in a shape of a wire, various studies are being conducted to allow the bending directions due to a load to be uniform. Among them, Patent Literature 1 discloses a probe unit in which a test board accommodates contact probes each having a spring property that is curved at a contact portion between the contact probe and a contact body. In the contact probe, a portion having a spring property is commonly used as a conducting portion of an electric signal.

### Citation List

### Patent Literature

Patent Literature 1: Japanese Laid-open Patent Publication No. 4-277665

### Summary

### Technical Problem

However, the contact probe disclosed in Patent Literature 1 has a problem in that the contact probe needs to be long to secure a spring property, and conductivity is deteriorated due to an increased electrical resistance.

The present invention has been made in view of the above, and an object of the present invention is to provide a contact probe and a probe unit that have a spring property and can obtain a reliable and favorable conduction between contact objects.

### Solution to Problem

In order to solve the problem described above and achieve the object, a contact probe according to the present invention has a substantially flat plate shape and a uniform thickness, which connects different substrates to each other, the contact probe including: a first contact portion that has a side surface curved in an arc shape and comes into contact with one substrate at the side surface; a second contact portion that has a side surface curved in an arc shape and comes into contact with the other substrate at the side surface; a connection portion that connects the first contact portion and the second contact portion with each other; and an elastic portion that extends from the second contact portion, has a portion curved in an arc shape, and is elastically deformed due to a load applied to the first contact portion and the second contact portion.

In the contact probe according to the present invention as set forth in the invention described above, a width of the elastic portion is smaller than a width of the connection portion.

In the contact probe according to the present invention as set forth in the invention described above, the connection portion is formed in an arc shape.

In the contact probe according to the present invention as set forth in the invention described above, the elastic portion has a portion formed in a linear shape.

In the contact probe according to the present invention as set forth in the invention described above, the elastic portion is positioned between a first plane that is tangent to the first contact portion and a second plane that is parallel to the first plane and tangent to the second contact portion.

A probe unit according to the present invention includes: a contact probe having a substantially flat plate shape, which includes a first contact portion that has a side surface curved in an arc shape and comes into contact with one substrate at the side surface, a second contact portion that has a side surface curved in an arc shape and comes into contact with the other substrate at the side surface, a connection portion that connects the first contact portion and the second contact portion with each other, and an elastic portion that extends from the second contact portion, has a portion curved in an arc shape, and is elastically deformed due to a load applied to the first contact portion and the second contact portion; and a holding portion that holds the contact probe.

In the probe unit according to the present invention as set forth in the invention described above, the holding portion is provided with a hole that has a diameter equal to a diameter of the elastic portion and accommodates and fixes an end portion at a side other than the connection portion side of the elastic portion.

In the probe unit according to the present invention as set forth in the invention described above, at least a part of the holding portion comes into contact with the second contact portion.

In the probe unit according to the present invention as set forth in the invention described above, an outer edge of the second contact portion that connects contact portions, which are respectively in contact with the other substrate and the holding portion in a state where no load is applied, has an R-shape, wherein a length between the contact portions is shortest.

In the probe unit according to the present invention as set forth in the invention described above, the holding portion is provided with a slit that is able to accommodate the contact probe.

### Advantageous Effects of Invention

The contact probe and probe unit according to the present invention have an effect of obtaining a reliable and favorable conduction between contact objects while ensuring a spring property since different positions of the contact probe correspond to a portion having conductivity and a portion having a spring property, respectively.

### Brief Description of Drawings

FIG. 1 is a perspective view illustrating a configuration of a probe unit according to a first embodiment of the present invention.
FIG. 2 is an exploded perspective view illustrating a configuration of a substantial part of the probe unit illustrated in FIG. 1.
FIG. 3 is an exploded perspective view illustrating a configuration of a substantial part of the probe unit illustrated in FIG. 1.
FIG. 4 is a perspective view illustrating a configuration of a substantial part of the probe unit illustrated in FIG. 1.
FIG. 5 is a perspective view illustrating a contact probe according to the first embodiment of the present invention.
FIG. 6 is a partial cross-sectional view illustrating a configuration of a substantial part of the probe unit illustrated in FIG. 1.
FIG. 7 is a partial cross-sectional view illustrating a configuration of a substantial part of the probe unit illustrated in FIG. 1.
FIG. 8 is a partial cross-sectional view illustrating a configuration of a substantial part of the probe unit illustrated in FIG. 1.
FIG. 9 is a perspective view illustrating a contact probe according to modified example 1 of the first embodiment of the present invention.
FIG. 10 is a perspective view illustrating a contact probe according to modified example 2 of the first embodiment of the present invention.
FIG. 11 is a perspective view illustrating a contact probe according to modified example 3 of the first embodiment of the present invention.
FIG. 12 is a perspective view illustrating a contact probe according to modified example 4 of the first embodiment of the present invention.
FIG. 13 is a perspective view illustrating a contact probe according to modified example 5 of the first embodiment of the present invention.
FIG. 14 is a perspective view illustrating a contact probe according to a second embodiment of the present invention.
FIG. 15 is a partial cross-sectional view illustrating a configuration of a substantial part of a probe unit according to the second embodiment of the present invention.
FIG. 16 is a partial cross-sectional view illustrating a configuration of a substantial part of the probe unit according to the second embodiment of the present invention.
FIG. 17 is a perspective view illustrating a semiconductor integrated circuit according to a modified example of an embodiment of the present invention.

### Description of Embodiments

Hereinafter, embodiments of the present invention will be described in detail with reference to drawings. The present invention is not limited to the embodiments described below. Further, each drawing referred to in descriptions below merely illustrates a schematic shape, size, and positional relation to an extent in which content of the present invention is understandable. That is, the present invention is not limited to the shape, size, and positional relation illustrated in each drawing.

### (First Embodiment)

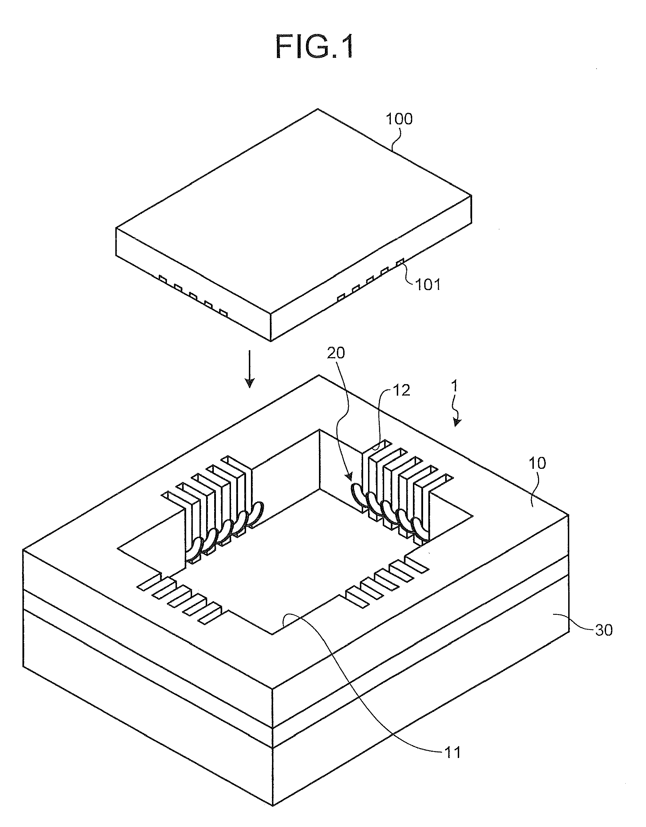

FIG. 1 is a perspective view illustrating a configuration of a probe unit according to a first embodiment of the present invention. A probe unit 1 illustrated FIG. 1 is a device used when an electrical property test is conducted on a semiconductor integrated circuit 100 corresponding to a test object, and is a device electrically connecting between the semiconductor integrated circuit 100 and a circuit board 30 that outputs a signal for testing to the semiconductor integrated circuit 100. The first embodiment will be described on the assumption that the semiconductor integrated circuit 100 is a QFN (Quad Flat Non-leaded package) including electrodes 101.

The probe unit 1 includes conductive contact probes 20 (hereinafter, referred to as "probes 20") that come into contact with two different contact objects, that is, the semiconductor integrated circuit 100 and the circuit board 30, a probe holder 10 as a holding portion that accommodates and holds the probes 20 according to a predetermined pattern, and the circuit board 30 that abuts a bottom of the probe holder 10, and outputs a signal for testing to the semiconductor integrated circuit 100 via the probes 20.

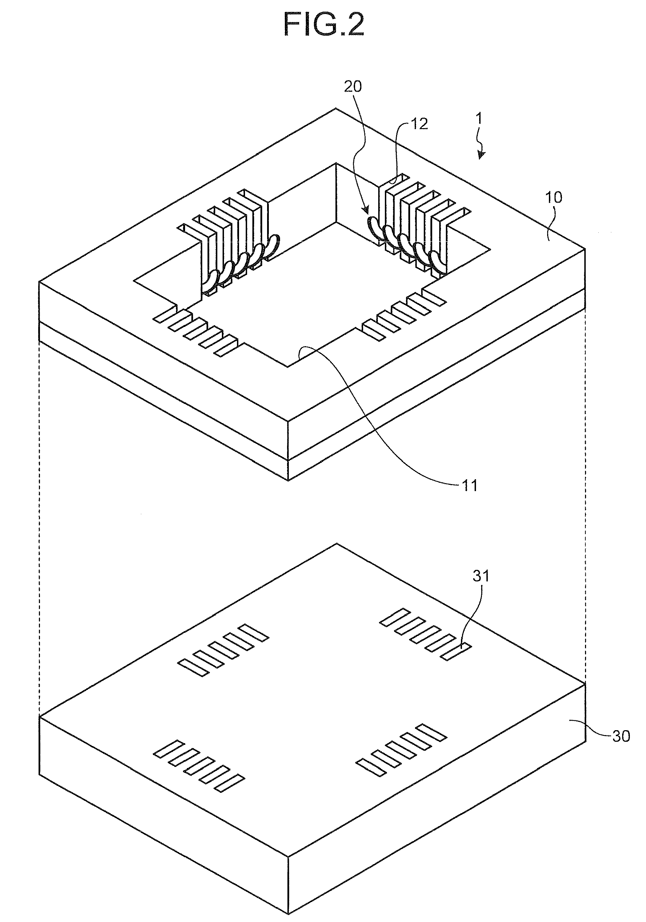

As illustrated in FIG. 2, the circuit board 30 includes electrodes 31 that output a signal for testing to the semiconductor integrated circuit 100 via the probes 20. The electrodes 31 are disposed on the circuit board 30 corresponding to the probes 20 held in the probe holder 10. Incidentally, the probe holder 10 and the circuit board 30 may be connected to each other through a screw and the like, or may be bonded to each other through an adhesive agent or a seal member. Any type of adhesion may be used if the adhesion does not hinder a contact between the probes 20 and the electrodes 31.

The probe holder 10 is formed using an insulating material, and includes an accommodation portion 11 in which an accommodation space capable of accommodating the semiconductor integrated circuit 100 is formed, and slits 12 for holding the probes 20 in a predetermined pattern. The slits 12 hold the probes 20 such that tip ends of the probes 20 protrude on the accommodation portion 11 side. Further, the slits 12 are formed at positions where the respective probes 20 come into contact with the corresponding electrodes 101 of the semiconductor integrated circuit 100 when the semiconductor integrated circuit 100 is accommodated in the accommodation portion 11.

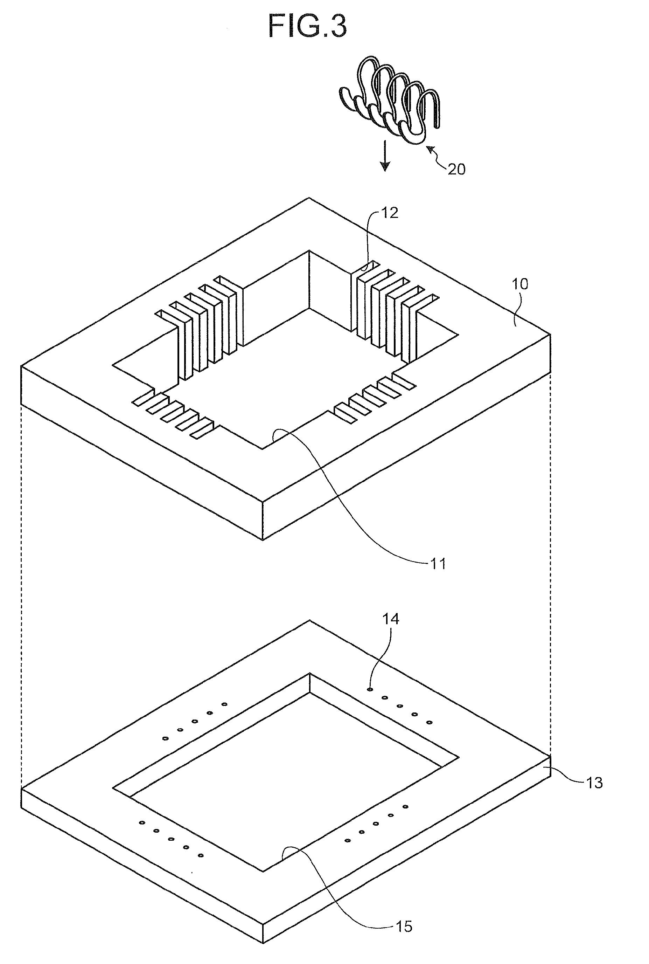

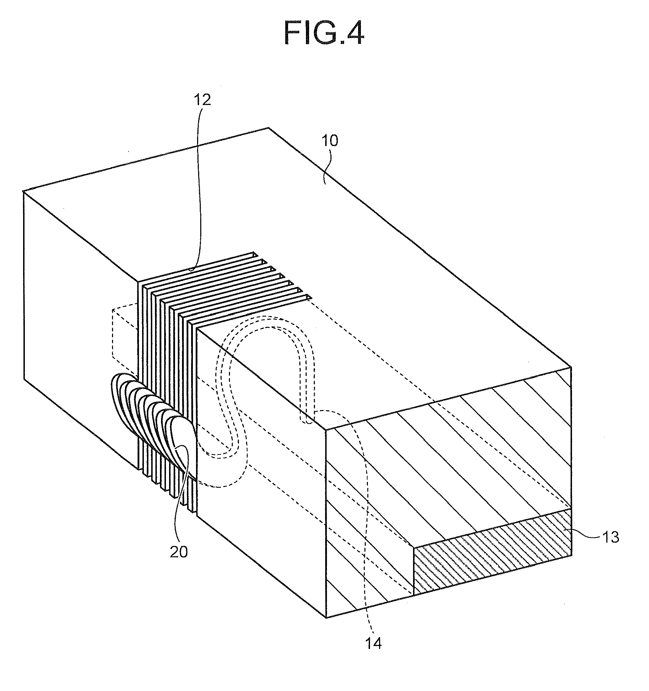

FIG. 3 is an exploded perspective view illustrating a configuration of a substantial part of the probe unit 1 illustrated in FIG. 1. FIG. 4 is a perspective view illustrating a configuration of a substantial part of the probe unit 1 illustrated in FIG. 1. As illustrated in FIGS. 3 and 4, a probe holder 10 has a configuration in which a fixing member 13 that fixes probes 20 is detachably connected to an outer circumference of its bottom. The fixing member 13 is formed using an insulating material, and includes an opening 15 greater than the probe holder 10, and holes 14 that hold and fix the probes 20. The probe holder 10 is formed in a cuboid shape by being fitted with the fixing member 13 at a notched portion corresponding to the fixing member 13, and constitutes a holding portion that holds the probes 20. The holes 14 accommodate end portions of the probes 20 inserted in the slits 12, and hold the probes 20 such that the other tip ends of the probes 20 are positioned at predetermined positions of the accommodation portion 11. Incidentally, as long as it is possible to fix the probes 20 at a predetermined interval and in a predetermined direction, only the fixing member 13 may constitute the holding portion, and the probe unit 10 and the holes 14 of the fixing member 13 may be integrally formed.

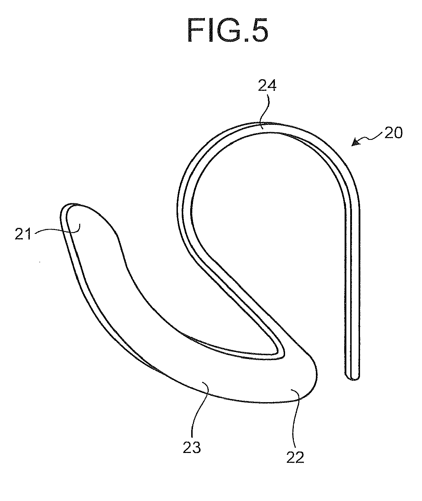

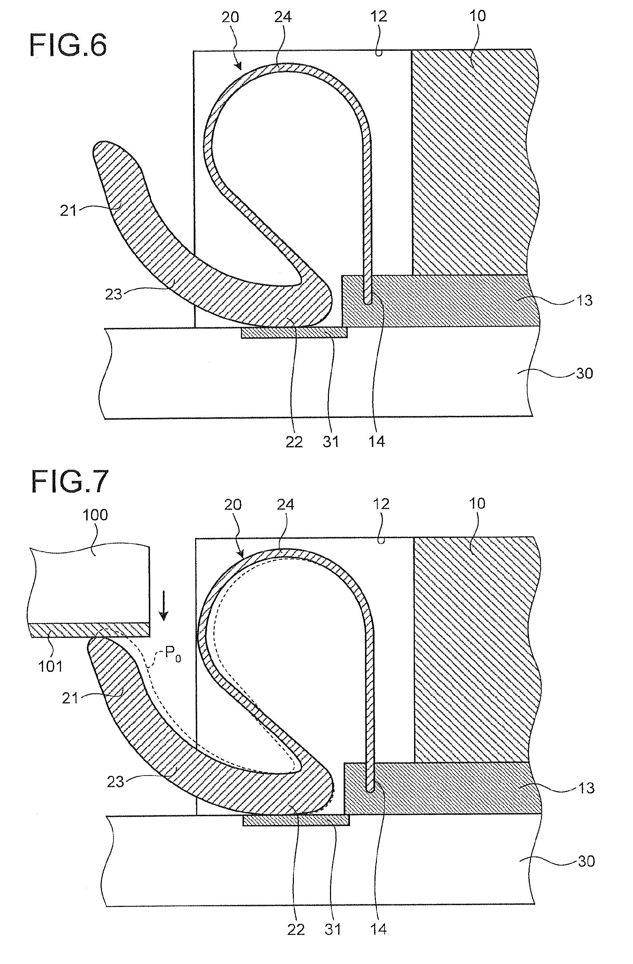

FIG. 5 is a perspective view illustrating the probe 20 according to the first embodiment of the present invention. Further, FIG. 6 is a cross-sectional view cut by a plane passing through a center of the slit 12 illustrated in FIG. 1. The probe 20 illustrated in FIGS. 5 and 6 corresponds to a substantially flat plate having a uniform thickness, and includes a first contact portion 21 that has a side surface curved in an arc shape at a tip end and comes into contact with the semiconductor integrated circuit 100 at the side surface, a second contact portion 22 that has a side surface curved in an arc shape and comes into contact with the circuit board 30 at the side surface, a strip-shaped connection portion 23 that connects the first contact portion 21 and the second contact portion 22 with each other, and an elastic portion 24 that extends from the second contact portion 22, has a portion curved in an arc shape, and is elastically deformed due to a load applied to the first contact portion 21 and the second contact portion 22. The probe 20 is formed using an alloy such as copper, nickel, iron, tungsten, and the like. Incidentally, after the formation using an elastic material, a surface may be subjected to a plating process.

Referring to the cross-sectional view illustrated in FIG. 6, the side surface of the second contact portion 22 curved in an arc shape abuts the electrode 31 of the circuit board 30 while being held by the probe holder 10.

A width of the elastic portion 24 is narrower than a width of the connection portion 23. Thus, the elastic portion 24 is more likely to be elastically deformed than another portion in response to a load applied to the first contact portion 21 or the second contact portion 22. Incidentally, a ratio of the width of the elastic portion 24 to the width of the connection portion 23 is not limited if the elastic portion 24 is preferentially elastically deformable. Further, an end portion of the elastic portion 24 at a direction different from that of the second contact portion 22 extends in a linear shape, a tip end of the linear-shaped portion is inserted in and attached to the hole 14, and thus the probe 20 is held by the probe holder 10.

FIG. 7 is a partial cross-sectional view illustrating a state in which a load is applied to the first contact portion 21 or the second contact portion 22. As illustrated in FIG. 7, when the first contact portion 21 comes into contact with the electrode 101 of the semiconductor integrated circuit 100, and a load is applied in a direction of an arrow in the drawing, a curved portion of the elastic portion 24 is elastically deformed. Here, a dashed line P₀ depicts a position of the probe 20, in a state in which no load is applied, illustrated in FIG. 6.

When an external load is applied to the first contact portion 21, the first contact portion 21 and the second contact portion 22 (including the connection portion 23) are not elastically deformed, and move while abutting the electrode 101 and the electrode 31 in response to the load. Further, the elastic portion 24 is elastically deformed in response to the load transferred through the connection portion 23 and the second contact portion 22. Incidentally, a large portion of flowing currents flows through the first contact portion 21, the connection portion 23, and the second contact portion 22.

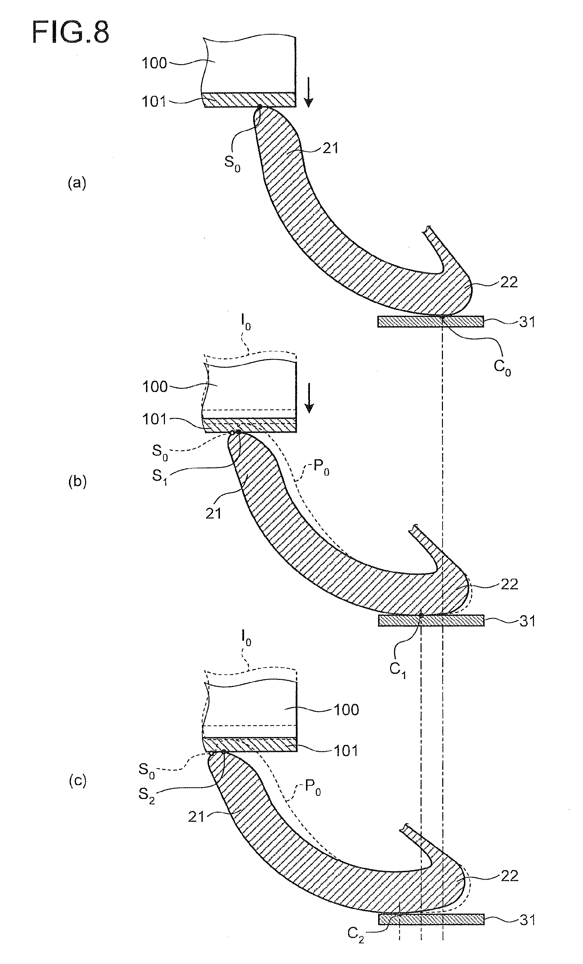

FIG. 8 is a drawing illustrating a contact state between the first contact portion 21 and the electrode 101 and a contact state between the second contact portion 22 and the electrode 31 before and after a load is applied to the first contact portion 21. First, FIG. 8(a) illustrates a state in which the electrode 101 of the semiconductor integrated circuit 100 abuts the first contact portion 21 (a state in which no load is applied). In this instance, a contact point between the first contact portion 21 and the electrode 101 is denoted by So, and a contact point between the second contact portion 22 and the electrode 31 is denoted by C₀.

Referring to FIG. 8(a), when the semiconductor integrated circuit 100 moves in a direction of an arrow, a load is applied to the first contact portion 21, and thus the first contact portion 21 is pressed downward. Due to the movement of the first contact portion 21, the contact point between the first contact portion 21 and the electrode 101 and the contact point between the second contact portion 22 and the electrode 31 are displaced to S₁ and C₁, respectively (FIG. 8(b)). Incidentally, a dashed line P₀ depicts a position of the probe 20, in a state in which no load is applied, illustrated in FIG. 8(a), and a dashed line I₀ depicts a position of the semiconductor integrated circuit 100 illustrated in FIG. 8(a).

Here, the first contact portion 21 and the second contact portion 22 rotate on the electrode 101 and the electrode 31, respectively, and thus, the contact points are moved. Therefore, each contact portion exerts a small frictional force and the like against each electrode, and it is possible to suppress an abrasion of each of the contact portions and the electrodes.

When the semiconductor integrated circuit 100 is moved in a direction of an arrow illustrated in FIG. 8(b) (a downward direction of the drawing), the first contact portion 21 is further pressed downward, and similarly to FIG. 8(b), the contact point between the first contact portion 21 and the electrode 101 and the contact point between the second contact portion 22 and the electrode 31 are displaced to S₂ and C₂, respectively (FIG. 8(c)).

The probe unit 1 according to the first embodiment described above includes a portion used for an electrical conduction and a portion having a spring property formed in different shapes in the same probe, and thus a probe can be designed without increasing an electrical conduction path by ensuring a spring property, a reliable electrical conduction can be carried out, and a spring property of the probe can be ensured. Further, since a contact point is moved by rotating each contact portion in response to a contact with an electrode, it is possible to reduce a fractional force between the contact portion and the electrode, and suppress an abrasion of the contact portion and the electrode.

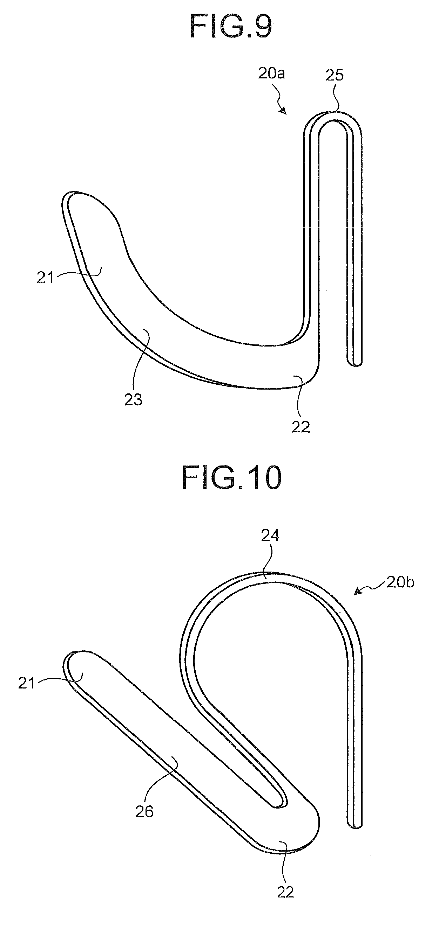

Incidentally, the shape of the probe is not limited if the elastic portion has a spring property. FIG. 9 is a perspective view illustrating a probe 20a that corresponds to modified example 1 of the first embodiment.

As illustrated in FIG. 9, the probe 20a includes the first contact portion 21, the second contact portion 22, and the connection portion 23 connecting between the first contact portion 21 and the second contact portion 22 described in the foregoing, and includes an elastic portion 25 that has a portion curved in an arc shape, and is elastically deformed by a load applied to the first contact portion 21 and the second contact portion 22.

The elastic portion 25 is curved such that linear portions at both end portions are parallel to each other. Further, a curvature radius of a curved portion of the elastic portion 25 is smaller than a curvature radius of the elastic portion 24 illustrated in FIG. 5. Incidentally, a width of the elastic portion 25 is smaller than a width of the connection portion 23.

The probe 20a described above is effective for downsizing a device since the curved portion of the elastic portion 25 is small. Further, in a case where a direction in which the probe 20 comes into contact with the semiconductor integrated circuit 100 corresponds to the direction illustrated in FIGS. 7 and 8, a region in which the curved portion of the elastic portion 25 is formed does not overlap a region in which the connection portion 23 in a direction in which the semiconductor integrated circuit 100 moves, and thus the probe can be further downsized by shortening the connection portion 23.

FIG. 10 is a perspective view illustrating a probe 20b that corresponds to modified example 2 of the first embodiment. As illustrated in FIG. 10, the probe 20b includes the first contact portion 21 and the second contact portion 22 described in the foregoing, a linear-shaped connection portion 26 connecting between the first contact portion 21 and the second contact portion 22, and an elastic portion 24 that has a portion curved in an arc shape and is elastically deformed due to a load applied to the first contact portion 21 and the second contact portion 22.

The probe 20b has an effect similar to the effect of the first embodiment described above, and is particularly useful when a size of an electrode is small since a curvature radius of a portion of the second contact portion 22 that is in contact with the electrode is small, and a distance at which a rotation is performed on the electrode is short. Further, a conduction distance of the connection portion 26 is shortened when compared to the arc-shaped connection portion 23, and thus a further stable conduction can be obtained.

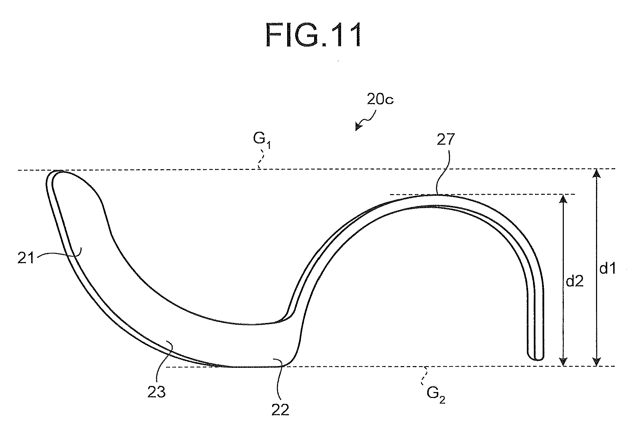

FIG. 11 is a perspective view illustrating a probe 20c corresponding to modified example 3 of the first embodiment. As illustrated in FIG. 11, the probe 20c includes the first contact portion 21, the second contact portion 22, and the connection portion 23 connecting between the first contact portion 21 and the second contact portion 22 described in the foregoing, and includes an elastic portion 27 that extends from the second contact portion 22, has a portion curved in an arc shape, and is elastically deformed by a load applied to the first contact portion 21 and the second contact portion 22. Incidentally, a width of the elastic portion 27 is smaller than a width of the connection portion 23.

The elastic portion 27 is positioned between a first plane G₁ tangent to the first contact portion 21 and a second plane G₂ that is parallel to the first plane G₁, and is tangent to the second contact portion 22. That is, the elastic portion 27 is curved such that a distance d2 from the second plane G₂ to a farthest point of the elastic portion 27 with respect to the second plane G₂ is shorter than a distance d1 between the first plane G₁ and the second plane G₂.

The probe 20c has an effect similar to the effect of the first embodiment described above, and for example, in a case where the probe 20c is held in the probe holder 1, and a test is conducted, even when the semiconductor integrated circuit 100 approaches a region including a formation region of the elastic portion 27 from above, the test can be conducted without a contact between the elastic portion 27 and the semiconductor integrated circuit 100.

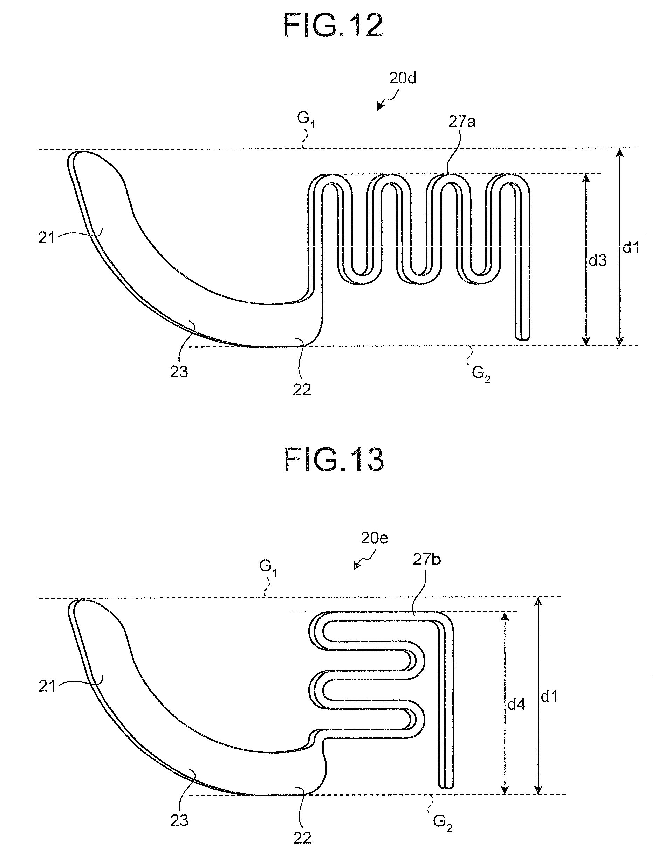

Further, as in modified example 4 illustrated in FIG. 12, it is possible to employ a probe 20d having an elastic portion 27a that extends in a zig-zag manner such that a concavity and convexity is repeated in a reversely curved portion. The elastic portion 27a forms a shape that reciprocates in a direction substantially perpendicular to planes G₁ and G₂, and extends in a direction parallel to the planes G₁ and G₂. In this case, a shape is curved such that a distance d3 from the second plane G₂ to a farthest point of the elastic portion 27a with respect to the second plane G₂ is shorter than a distance d1 between the first plane G₁ and the second plane G₂.

Further, as in modified example 5 illustrated in FIG. 13, it is possible to employ a probe 20e having an elastic portion 27b that extends in a zig-zag manner such that a concavity and convexity is repeated in a reversely curved portion. The elastic portion 27b forms a shape that reciprocates in a direction parallel to planes G₁ and G₂, and extends in a direction perpendicular to the planes G₁ and G₂. In this case, a shape is curved such that a distance d4 from the second plane G₂ to a farthest point of the elastic portion 27b with respect to the second plane G₂ is shorter than a distance d1 between the first plane G₁ and the second plane G₂.

### (Second Embodiment)

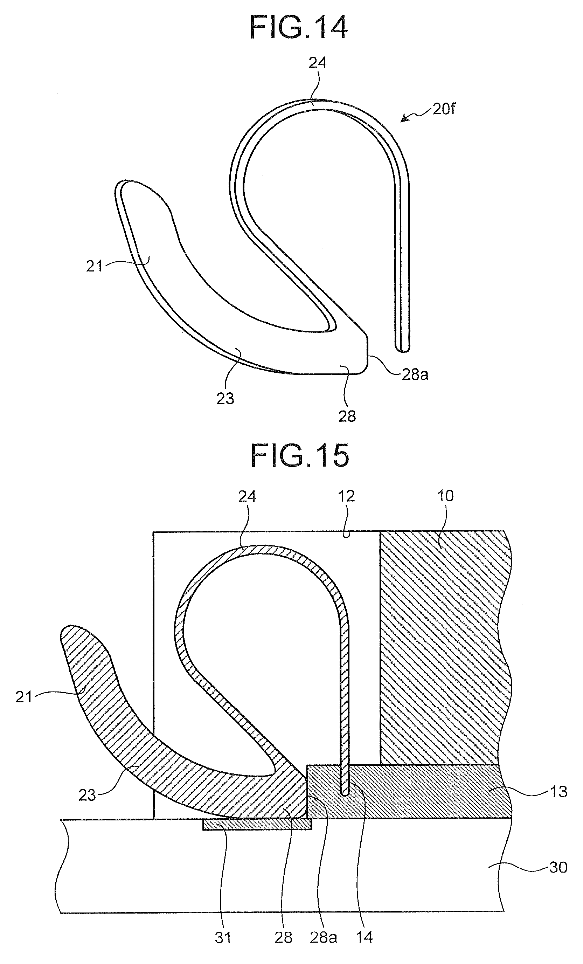

The first embodiment has been described on the assumption that the second contact portion of the probe does not abut on a wall surface of the fixing member. In a second embodiment, a case where the second contact portion abuts on a wall surface of the fixing member will be described. FIG. 14 is a perspective view illustrating a configuration of a probe 20f according to the second embodiment of the present invention. Incidentally, the same reference number is applied to the same component as that of the probe unit 1 described with reference to FIG. 1 and the like.

The probe 20f illustrated in FIG. 14 corresponds to a substantially flat plate having a uniform thickness, and includes a first contact portion 21 that has a side surface curved in an arc shape at a tip end, and comes into contact with the semiconductor integrated circuit 100 illustrated in FIG. 1 at the side surface, a second contact portion 28 that has a side surface curved in an arc shape, and comes into contact with the circuit board 30 illustrated in FIG. 1 at the side surface, a connection portion 23 that connects the first contact portion 21 and the second contact portion 28 with each other, and an elastic portion 24 that extends from the second contact portion 28, has a portion curved in an arc shape, and is elastically deformed due to a load applied to the first contact portion 21 and the second contact portion 28.

The second contact portion 28 has a side surface 28a formed on a plane corresponding to a wall surface of a fixing member 13, and fixes the probe 20f by abutting on the wall surface of the fixing member 13. FIG. 15 is a partial cross-sectional view illustrating a case where the probe 20f illustrated in FIG. 14 is introduced in the probe unit 1 illustrated in FIG. 1.

As illustrated in FIG. 15, the probe 20f held in a hole 14 of the fixing member 13 abuts on the wall surface of the fixing member 13 on the side surface 28a of the second contact portion 28. In this instance, since the side surface 28a is formed along the wall surface of the fixing member 13, it is possible to adjust a direction in which the connection portion 23 and the first contact portion 21 protrude from a slit 12 by abutting of the second contact portion 28.

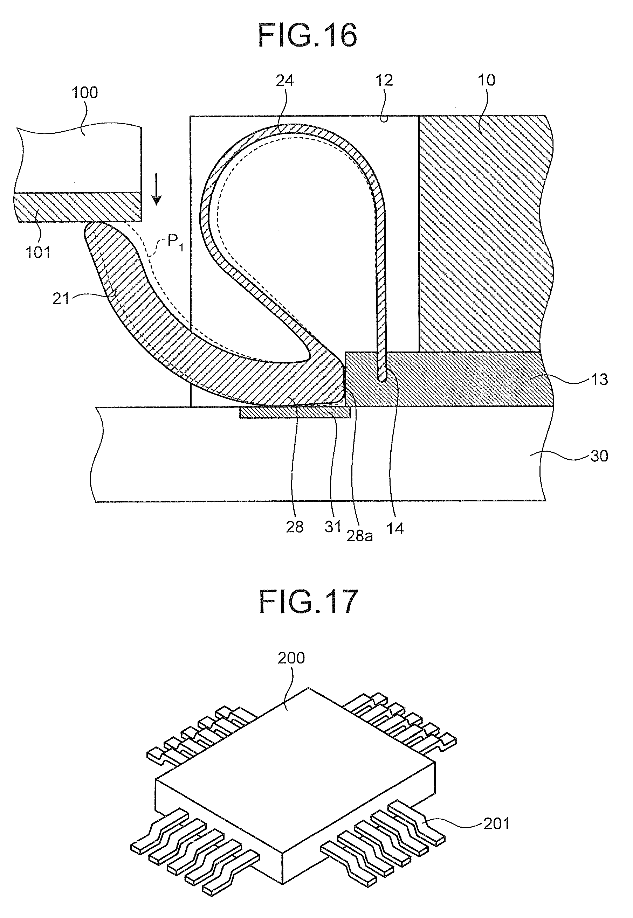

FIG. 16 is a partial cross-sectional view illustrating a state in which the first contact portion 21 is pressed downward by the semiconductor integrated circuit 100. As in the first embodiment, the first contact portion 21 that comes into contact with an electrode 101 and the second contact portion 28 that comes into contact with an electrode 31 rotate on a surface of each electrode by a movement of the semiconductor integrated circuit 100 (a direction of an arrow in the drawing) to come into contact with each electrode, thereby electrically conducting between the semiconductor integrated circuit 100 and the circuit board 30. Further, the curved portion of the elastic portion 24 is elastically deformed by a load applied to the probe 20f. A dashed line P₁ depicts a position of the probe 20f in a case where no load is applied from the semiconductor integrated circuit 100 illustrated in FIG. 15.

When the probe 20f according to the second embodiment described above is held in the hole 14 of the fixing member 13, the side surface 28a abutting on the wall surface of the fixing member 13 has an effect of an alignment, and thus it is possible to easily dispose the probe at a predetermined position of the probe unit.

Further, in an outer edge of the second contact portion 28, an outer edge that connects contact portions, which are respectively in contact with the fixing member 13 and the electrode 31, preferably has an R-shape, wherein a length between the contact portions is the shortest. A radius of the R-shape satisfies an inequality 0 ≤ R < 0.1 (mm). Preferably, the radius of the R-shape satisfies an inequality 0 < R < 50 (µm).

Forming the second contact portion 28 in the above-described R-shape enables the second contact portion to further efficiently move a contact point along a surface of an electrode, and thus an abrasion of the electrode can be further suppressed.

Incidentally, a side surface 28a may be formed on the probe 20 illustrated in FIG. 5 or the probes 20a to 20e illustrated in FIGS. 9 to 13 to abut on a wall surface of the fixing member 13. When the second contact portion abuts on the wall surface of the fixing member 13, an effect of an alignment can be obtained.

Incidentally, the first and second Embodiments have been described on the assumption that the semiconductor integrated circuit is a QFN that does not have a lead on the outside. However, as illustrated in FIG. 17, it is possible to employ a semiconductor integrated circuit 200 (Quad Flat Package: QFP) having a lead 201.

### Industrial Applicability

As described in the foregoing, a contact probe according to the present invention is useful for connecting an electric circuit board and the like, thereby carrying out an electrical conduction.

### Reference Signs List

- 1: PROBE UNIT
- 10: PROBE HOLDER
- 11: ACCOMMODATION PORTION
- 12: SLIT
- 13: FIXING MEMBER
- 14: HOLE
- 15: OPENING
- 20, 20a, 20b, 20c, 20d, 20e, 20f: PROBE
- 21: FIRST CONTACT PORTION
- 22, 28: SECOND CONTACT PORTION
- 23, 26: CONNECTION PORTION
- 24, 25, 27, 27a, 27b: ELASTIC PORTION
- 30: CIRCUIT BOARD
- 31, 101: ELECTRODE
- 100, 200: SEMICONDUCTOR INTEGRATED CIRCUIT
- 201: LEAD

## Claims

1. A contact probe having a substantially flat plate shape and a uniform thickness, which connects different substrates to each other, the contact probe comprising:
a first contact portion that has a side surface curved in an arc shape and comes into contact with one substrate at the side surface;
a second contact portion that has a side surface curved in an arc shape and comes into contact with the other substrate at the side surface;
a connection portion that connects the first contact portion and the second contact portion with each other; and
an elastic portion that extends from the second contact portion, has a portion curved in an arc shape, and is elastically deformed due to a load applied to the first contact portion and the second contact portion.

2. The contact probe according to claim 1, wherein a width of the elastic portion is smaller than a width of the connection portion.

3. The contact probe according to claim 1 or 2, wherein the connection portion is formed in an arc shape.

4. The contact probe according to any one of claims 1 to 3, wherein the elastic portion has a portion formed in a linear shape.

5. The contact probe according to any one of claims 1 to 3, wherein the elastic portion is positioned between a first plane that is tangent to the first contact portion and a second plane that is parallel to the first plane and tangent to the second contact portion.

6. A probe unit, comprising:
a contact probe having a substantially flat plate shape, which includes a first contact portion that has a side surface curved in an arc shape and comes into contact with one substrate at the side surface, a second contact portion that has a side surface curved in an arc shape and comes into contact with the other substrate at the side surface, a connection portion that connects the first contact portion and the second contact portion with each other, and an elastic portion that extends from the second contact portion, has a portion curved in an arc shape, and is elastically deformed due to a load applied to the first contact portion and the second contact portion; and
a holding portion that holds the contact probe.

7. The probe unit according to claim 6, wherein the holding portion is provided with a hole that has a diameter equal to a diameter of the elastic portion and accommodates and fixes an end portion at a side other than the connection portion side of the elastic portion.

8. The probe unit according to claim 6 or 7, wherein at least a part of the holding portion comes into contact with the second contact portion.

9. The probe unit according to claim 8, wherein an outer edge of the second contact portion that connects contact portions, which are respectively in contact with the other substrate and the holding portion in a state where no load is applied, has an R-shape, wherein a length between the contact portions is shortest.

10. The probe unit according to any one of claims 6 to 9, wherein the holding portion is provided with a slit that is able to accommodate the contact probe.
